# EUROPEAN PATENT APPLICATION

(11) **EP 3 041 133 A1**
(43) Date of publication of application: **06.07.2016**
(21) Application number: 14840906.3
(22) Date of filing: 14.02.2014
(51) Int. Cl.: H03F 1/07, H03F 3/24

(54) **POWER AMPLIFICATION DEVICE AND CONTROL METHOD FOR POWER AMPLIFICATION DEVICE**

(30) Priority: 28.08.2013 JP 2013177248
(71) Applicant: Kabushiki Kaisha Toshiba, Minato-ku Tokyo 105-8001 (JP)
(72) Inventor: OTSUKI Shunya, Tokyo 105-8001 (JP); ITAGAKI Hiromu, Tokyo 105-8001 (JP); HASUIKE Kenichi, Tokyo 105-8001 (JP)
(74) Representative: Hoffmann Eitle
(86) International application number: PCT/JP2014/053541
(87) International publication number: WO 2015/029462

(57) **Abstract**

According to some embodiments, a power amplification apparatus has a Doherty amplifier, a voltage adjuster, and a central processor. The Doherty amplifier includes a carrier amplifier and a peak amplifier. Each of the carrier amplifier and the peak amplifier amplify an input signal. The Doherty amplifier outputs an output signal by combining the amplified signals. The voltage adjuster supplies a control voltage to each of the carrier amplifier and the peak amplifier. The central processor includes a table storing control voltage information of each of the carrier amplifier and the peak amplifier which are included in the Doherty amplifier. The control voltage information is determined in accordance with operations in an average output power of the Doherty amplifier. The central processor controls the voltage adjuster to supply a control voltage, which corresponds to the control voltage information stored in the table, to each of the carrier amplifier and the peak amplifier.

## Description

### Technical Field

Embodiments described herein relate generally to a power amplification apparatus and a control method of a power amplification apparatus.

### Background Art

Conventionally, a Doherty amplifier having a carrier amplifier and a peak amplifier is used as a power amplification apparatus which amplifies an input power with high efficiency.

### Citation List

### Patent Literature

PTL1: WO 2008/075561

### Summary of Invention

### Technical Problem

In an actual operation of the power amplification apparatus, there is a case that the power amplification apparatus is used with an average output power level reduced (case of a power reduction operation). In this case, there is a case that the power amplification apparatus is operated in a state that power efficiency is decreased from a peak point.

One aspect of the present invention provides a power amplification apparatus and a control method of a power amplification apparatus, which enable to keep a high efficiency even if the power amplification apparatus performs the power reduction operation.

### Solution to Problem

According to some embodiments, a power amplification apparatus has a Doherty amplifier, a voltage adjuster, and a central processor. The Doherty amplifier includes a carrier amplifier and a peak amplifier. Each of the carrier amplifier and the peak amplifier amplify an input signal. The Doherty amplifier outputs an output signal by combining the amplified signals. The voltage adjuster supplies a control voltage to each of the carrier amplifier and the peak amplifier. The central processor includes a table storing control voltage information of each of the carrier amplifier and the peak amplifier which are included in the Doherty amplifier. The control voltage information is determined in accordance with operations in an average output power of the Doherty amplifier. The central processor controls the voltage adjuster to supply a control voltage, which corresponds to the control voltage information stored in the table, to each of the carrier amplifier and the peak amplifier.

According to some embodiments, a power amplification apparatus has a Doherty amplifier, a voltage adjuster, and a central processor. The Doherty amplifier includes a carrier amplifier and a peak amplifier. Each of the carrier amplifier and the peak amplifier amplify an input signal. The Doherty amplifier outputs an output signal by combining the amplified signals. The voltage adjuster supplies a control voltage to each of the carrier amplifier and the peak amplifier. The central processor includes a table storing control voltage information of each of the carrier amplifier and the peak amplifier which are included in the Doherty amplifier. The control voltage information is determined in accordance with operations in an average output power of the Doherty amplifier. A control method of the power amplification apparatus includes controlling, by the central processor, the voltage adjuster to supply a control voltage, which corresponds to the control voltage information stored in the table, to each of the carrier amplifier and the peak amplifier.

### Brief Description of Drawings

FIG. 1 is a drawing illustrating a configuration of a power amplification apparatus 200 which uses a general Doherty amplifier.
FIG. 2 is a drawing illustrating a power efficiency of the power amplification apparatus 200 shown in FIG. 1.
FIG. 3 is a drawing illustrating a configuration of a power amplification apparatus 100 of an embodiment.
FIG. 4 is a drawing illustrating a power efficiency of the power amplification apparatus 100 shown in FIG. 3.

### Description of Embodiments

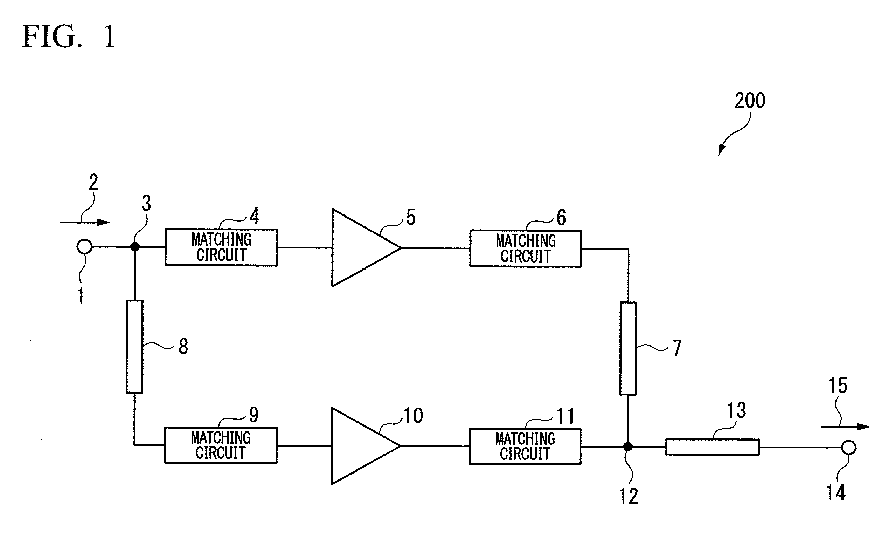

First, a problem of a power amplification apparatus which uses a general Doherty amplifier will be described below, with reference to FIG. 1. FIG. 1 is a drawing illustrating a configuration of a power amplification apparatus 200 which uses a general Doherty amplifier. The power amplification apparatus 200 includes an input terminal 1, a matching circuit 4, a carrier amplifier 5, a matching circuit 6, a λ/4 line 7, a λ/4 line 8, a matching circuit 9, a peak amplifier 10, a matching circuit 11, a λ/4 line 13, and an output terminal 14.

An input signal 2, which was supplied to the input terminal 1, is supplied to the matching circuit 4 through a branch point 3. The matching circuit 4 is a circuit which matches the input signal 2 with an input side of an amplifying element in the carrier amplifier 5. Because the amplifying element in the carrier amplifier 5 is biased to class A, class AB or class B, the carrier amplifier 5 amplifies the input signal 2 irrespective of a power level of the input signal 2. The carrier amplifier 5 supplies the amplified input signal 2 to the matching circuit 6. The matching circuit 6 is a circuit which matches an output of an amplifying element in the carrier amplifier 5 with an output of the carrier amplifier 5. If a power level of the input signal is low, the λ/4 line 7 acts as a circuit which performs an impedance conversion of the output of the carrier amplifier 5.

A phase of the input signal 2 which is branched at the branch point 3 is delayed by 90° by passing through the λ/4 line 8, and the input signal 2 is supplied to the matching circuit 9. The matching circuit 9 matches the input signal 2, of which phase delayed by 90°, with an input side of an amplifying element in the peak amplifier 10. Because the amplifying element in the peak amplifier 10 is biased to class C, if a power level of the input signal 2 is low, the peak amplifier 10 becomes in a non-operating state. On the other hand, if a power level of the input signal 2 is high, the peak amplifier 10 becomes in an operating state and amplifies the input signal 2. The peak amplifier 10 supplies the amplified input signal 2 to the matching circuit 11. The matching circuit 11 matches an output of an amplifying element in the peak amplifier 10 with an output of the peak amplifier 10. The output of the λ/4 line 7 and the output of the matching circuit 11 are combined at a combining point. The λ/4 line 13 performs an impedance conversion of the combined output in order to match the combined output with an impedance of a load connected to the output terminal 14. The signal which is performed the impedance conversion is supplied from the output terminal 14 as an output signal 15.

In the power amplification apparatus 200 including the configuration described above, in a case that a power of the input signal 2 is less than a predetermined input signal level, only the carrier amplifier 5 amplifies the input signal 2 linearly. On the other hand, in the power amplification apparatus 200, in a case that the power of the input signal 2 is equal to or more than the predetermined input signal level, both the carrier amplifier 5 and the peak amplifier 10 amplify the input signal linearly. Thereby, even if an amplifying characteristic of the carrier amplifier 5 is saturated, a linearity of an amplifying characteristic of the entire Doherty amplifier can be maintained.

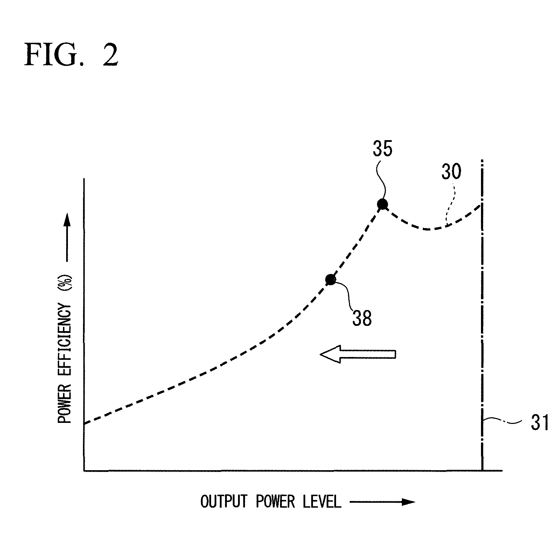

FIG. 2 is a drawing illustrating a power efficiency of the power amplification apparatus 200 shown in FIG. 1. In FIG. 2, the horizontal axis indicates an output power level of the output signal 15, and the vertical axis indicates a power efficiency of the power amplification apparatus 200.

As shown in FIG. 2, in a case that the output power level is a saturation output power level 31, the carrier amplifier 5 and the peak amplifier 10 amplify at a saturation power level. In this case, the power efficiency 30 becomes peak. On the other hand, in a case of the power amplification apparatus 200 shown in FIG. 1, at an output level (turning point 35) which is displaced (back off) from the saturation output power level 31 by a predetermined level, only the carrier amplifier 5 amplifies at a saturation power level, and the peak amplifier 10 does not amplify. Also, in this case, the power efficiency 30 becomes peak. In this way, because the power amplification apparatus 200 shown in FIG. 1 has two output power levels where the power efficiency becomes peak, a range of the output power level, where the power efficiency is high, can be larger. Here, the "back off' means a difference between an average output power of an amplifier and the saturation output power.

By the way, in a case of a power amplification apparatus used as a transmitter for broadcasting, when a digital modulation signal is used as the input signal 2, it is necessary to make a PAR (Peak to Average Ratio) high and to make the "back off" equal to or more than the PAR. Therefore, in a case of a power amplification apparatus used as a transmitter for broadcasting, a high efficiency can be achieved by making the turning point 35 act as the average output power level. In this way, by using the Doherty amplifier, the power amplification apparatus can be used with high efficiency.

However, in a case that the power amplification apparatus 200 shown in FIG. 1 is used as a power amplification apparatus for broadcasting, in an actual operation, there is a case that the power amplification apparatus is used with the average output power level reduced (a case of performing a power reduction operation). In this case, the power efficiency moves along the allow direction shown in FIG. 2. Therefore, there is a problem that the power amplification apparatus 200 is operated at a point (for example, a point 38 shown in FIG. 2) where the power efficiency is decreased from the peak.

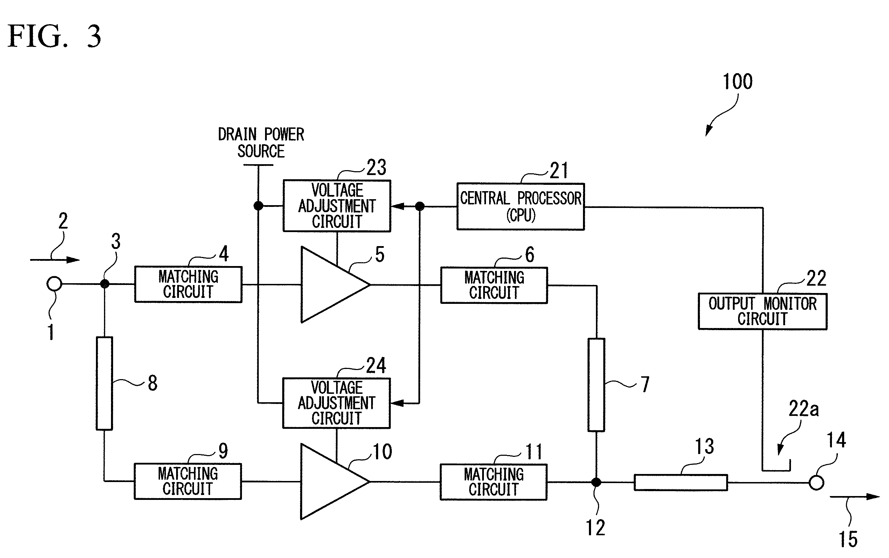

Hereinafter, a power amplification apparatus which can solve the problem will be described, with reference to FIG. 3.

In FIG. 3, parts corresponding to those of the power amplification apparatus 200 shown in FIG. 1 are assigned the same reference numerals, and the descriptions thereof will be omitted.

A power amplification apparatus 100 of an embodiment includes, adding to the power amplification apparatus 200 shown in FIG. 1, a central processor (CPU) 21, an output monitor circuit 22, a voltage adjustment circuit 23 (voltage adjuster), and a voltage adjustment circuit 24 (voltage adjuster).

The central processor 21 receives the average output power level of the output signal 15 from the output monitor circuit 22. In accordance with the average output power level, the central processor 21 determines a control voltage, which is to be applied by the voltage adjustment circuit 23, and a control voltage which is to be applied by the voltage adjustment circuit 24.

The voltage adjustment circuit 23 converts a voltage level of a drain power source to a level of the control voltage which is determined by the central processor 21. The voltage adjustment circuit 23 applies the converted voltage (control voltage) to a control terminal of the amplifying element in the carrier amplifier 5.

The voltage adjustment circuit 24 converts the voltage level of the drain power source to a level of the control voltage which is determined by the central processor 21. The voltage adjustment circuit 24 applies the converted voltage (control voltage) to a control terminal of the amplifying element in the peak amplifier 10. In this way, the power amplification apparatus 100 of the embodiment can independently set the drain voltage of the carrier amplifier 5 and the drain voltage of the peak amplifier 10 in accordance with the average output power level of the output signal 15.

A reason of independently controlling the drain voltage of the carrier amplifier 5 and the drain voltage of the peak amplifier 10 is described below.

In a case that the Doherty amplifier is a symmetrical Doherty amplifier, it is to correct an individual difference of devices (power amplifying elements). The symmetrical Doherty amplifier is an amplifier which includes two amplifiers (the carrier amplifier 5 and the peak amplifier 10) of which output characteristics are the same, and also includes matching circuits of which configurations are the same.

In a case that the Doherty amplifier is an asymmetrical Doherty amplifier, it is because there are a lot of cases that the peak amplifier is different in reduction voltage characteristics from the carrier amplifier. For example, the asymmetrical Doherty amplifier is a Doherty amplifier which includes a plurality of peak amplifiers 10 connected to each other in parallel. As another example of the asymmetrical Doherty amplifier, a Doherty amplifier, in which a power amplifying element of the peak amplifier is different from a power amplifying element of the carrier amplifier, may be used.

For example, the amplifying element of the carrier amplifier 5 includes a MOSFET (Metal-Oxide-Semiconductor Field-Effect Transistor). In a case that the drain voltage (control voltage) applied to a drain terminal (control terminal) of the amplifying element is reduced, the saturation power level of the output signal of the carrier amplifier 5 is also reduced.

For example, the amplifying element of the peak amplifier 10 includes a MOSFET. In a case that the drain voltage applied to a drain terminal of the amplifying element is reduced, the saturation power level of the output signal of the peak amplifier 10 is also reduced.

The central processor 21 includes a table which stores the control voltage applied to the carrier amplifier 5 and the control voltage applied to the peak amplifier 10. In the table, the control voltage (hereinafter, "control voltage Vd1") applied to the carrier amplifier 5 and the control voltage (hereinafter, "control voltage Vd2") applied to the peak amplifier 10 are associated with the average output power (predetermined power) of the output signal 15 which is output from the power amplification apparatus 100. For example, in accordance with the average output power level, values described below are stored in the table as the control voltages Vd1 and Vd2.

First, the control voltages Vd1_1 and Vd2_1 which are associated with the average output power of the output signal 15, which is output in a rated operation of the power amplification apparatus 100, are stored in the table.

Also, in the table included in the central processor 21, the average output power of the output signal 15, which is output in a power reduction operation of the power amplification apparatus 100, and control voltages Vd1_2 and Vd2_2 (control voltage information) are associated with each other as a combination, and a plurality of combinations thereof is preliminarily stored in the table. Each combination of the control voltage is calculated in accordance with a plurality of average output powers by conducting an experiment. For example, the control voltages Vd1_2 and Vd2_2 which are associated with an average output power level 200 [W], and the control voltages Vd1_3 and Vd2_3 which are associated with an average output power level 180 [W] are associated with the average output power and stored in the table. The experiment is performed to determine an optimal control voltage (voltage of which power efficiency becomes peak at the turning point). In the experiment, the control voltage Vd1 and the control voltage Vd2 are sequentially changed during the power reduction operation of the power amplification apparatus 100, and the power efficiency and the saturation output power at the average output power is confirmed, in order to determine the optimal control voltage.

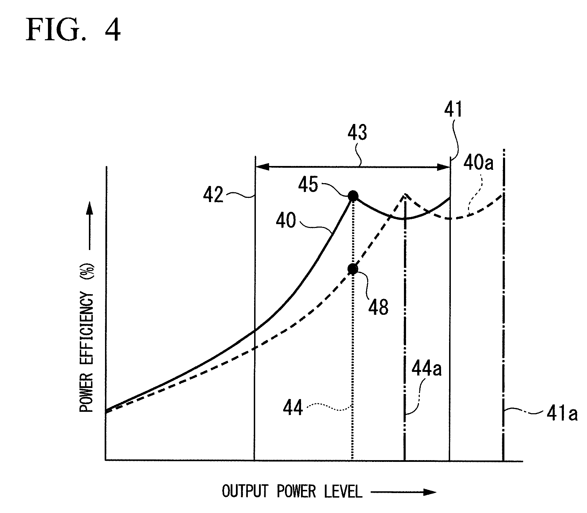

Next, a method of setting the control voltage, which is performed in the power reduction operation of the power amplification apparatus 100, is described below, with reference to a drawing. FIG. 4 is a drawing illustrating a power efficiency of the power amplification apparatus 100 shown in FIG. 3. In FIG. 4, the horizontal axis indicates an output power level of the output signal 15, and the vertical axis indicates a power efficiency of the power amplification apparatus 100.

The power efficiency 40a, which is shown in FIG. 4 by the broken line, indicates power efficiency during the rated operation of the power amplification apparatus 100. In the power efficiency 40a, there is a turning point at a point displaced from the saturation output power level 41 a by a back off amount (for example, 8 [dB]). Because the turning point is an average output power level 44a in the rated operation of the power amplification apparatus 100, the power amplification apparatus 100 can perform a high efficiency operation.

In a case that the power amplification apparatus 100 is operated in the power reduction operation, a power level of the input signal 2 is low with respect to the rated operation. The output monitor circuit 22 monitors the output signal 15, and supplies the average output power level of the output signal 15 to the central processor 21.

The central processor 21 reads, out of combinations of control voltages stored in the table, a combination of control voltages which is associated with the average output power level and which is to be used in the power reduction operation. For example, in a case that the average output power level is 200 [W], the control voltages Vd1_2 and Vd2_2, which are associated with 200 [W], are read out of the table. The central processor 21 controls the voltage adjustment circuit 23 to apply the control voltage Vd1_2 to the carrier amplifier 5, and controls the voltage adjustment circuit 24 to apply the control voltage Vd2_2 to the peak amplifier 10. In a state that these control voltages are applied, because the drain voltage applied to the carrier amplifier 5 and the drain voltage applied to the peak amplifier 10 are different from each other, the turning point 45 shown in FIG. 4 can be matched with the back off amount.

Thereby, the power efficiency in the power reduction operation of the power amplification apparatus 100 becomes the power efficiency 40 shown by the solid line in FIG. 4. Therefore, the power amplification apparatus 100 can make the turning point 45, where the power efficiency becomes peak, equal to the average output power, and can perform the power reduction operation.

For example, different from the present embodiment, the power amplification apparatus 200 does not apply voltages individually to the carrier amplifier 5 and the peak amplifier 10 in the power reduction operation. Therefore, referring to FIG. 4, in a case that the power amplification apparatus 200 performs the power reduction operation (for example, in a case that the power amplification apparatus 200 is operated with the solid line 44 used as the average output power level), the power amplification apparatus 200 operates at the point 48 of the power efficiency 40a which indicates the power efficiency of the rated operation. Therefore, the power amplification apparatus 200 operates with low power efficiency.

In contrast with this, in a case of the power amplification apparatus 100 of the present embodiment, as described above, the power efficiency in the power reduction operation is the power efficiency 40 shown in FIG. 4. Therefore, the power amplification apparatus 100 can operate with the output power level (broken line 44) at the turning point 45, which is used as the average output power level, and can operate with high power efficiency.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

For example, the control voltages Vd1_1 and Vd2_1 are set to be approximately the same voltage. It is because, if an asymmetrical Doherty amplifier is provided in the power amplification apparatus 100, the back off amount can be set to, for example, 8 [dB]. However, in the rated operation, in a case that a characteristic between output power and power efficiency at the turning point by providing the asymmetrical Doherty amplifier is finely adjusted, the control voltages Vd1_1 and Vd2_1 may be different from each other.

### Reference Signs List

100,200 ... power amplification apparatus, 1 ... input terminal, 2 ... input signal, 4, 6, 9, 10 ... matching circuit, 5 ... carrier amplifier, 7, 8 ... λ/4 line, 10 ... peak amplifier, 13 ... λ/4 line, 14 ... output terminal, 15 ... output signal, 21 ... central processor, 22 ... output monitor circuit, 23, 24 ...voltage adjustment circuit

## Claims

1. A power amplification apparatus comprising:
a Doherty amplifier which comprises a carrier amplifier and a peak amplifier, each of the carrier amplifier and the peak amplifier amplifying an input signal, the Doherty amplifier outputting an output signal by combining the amplified signals;
a voltage adjuster which supplies a control voltage to each of the carrier amplifier and the peak amplifier; and
a central processor which comprises a table storing control voltage information of each of the carrier amplifier and the peak amplifier which are comprised by the Doherty amplifier, the control voltage information being determined in accordance with operations in an average output power of the Doherty amplifier, the central processor controlling the voltage adjuster to supply a control voltage, which corresponds to the control voltage information stored in the table, to each of the carrier amplifier and the peak amplifier.

2. The power amplification apparatus according to claim 1, further comprising:
an output monitor circuit which detects an output power of the Doherty amplifier,
wherein the central processor controls the voltage adjuster to supply the control voltage to each of the carrier amplifier and the peak amplifier, based on a detection result of the output monitor circuit and the control voltage information of each of the carrier amplifier and the peak amplifier stored in the table.

3. The power amplification apparatus according to claims 1 or 2,
wherein the Doherty amplifier is an asymmetrical Doherty amplifier.

4. A control method of a power amplification apparatus which comprises a Doherty amplifier, a voltage adjuster, and a central processor, the Doherty amplifier comprises a carrier amplifier and a peak amplifier, each of the carrier amplifier and the peak amplifier amplify an input signal, the Doherty amplifier outputs an output signal by combining the amplified signals, the voltage adjuster supplies a control voltage to each of the carrier amplifier and the peak amplifier, the central processor comprises a table storing control voltage information of each of the carrier amplifier and the peak amplifier which are comprised by the Doherty amplifier, the control voltage information is determined in accordance with operations in an average output power of the Doherty amplifier, comprising:
controlling, by the central processor, the voltage adjuster to supply a control voltage, which corresponds to the control voltage information stored in the table, to each of the carrier amplifier and the peak amplifier.
